Europäisches Patentamt

European Patent Office

Office européen des brevets

(19)

(11) Veröffentlichungsnummer: **0 158 783**
**B1**

(12)

# EUROPÄISCHE PATENTSCHRIFT

(45) Veröffentlichungstag der Patentschrift :
09.08.89

(21) Anmeldenummer : 85101530.5

(22) Anmeldetag : 13.02.85

(51) Int. Cl.⁴ : **G 01 R 15/10, G 01 R 13/40**

(54) Digitales Messgerät zur quasi analogen Messwertanzeige.

(30) Priorität : 03.03.84 DE 3407942

(43) Veröffentlichungstag der Anmeldung :
23.10.85 Patentblatt 85/43

(45) Bekanntmachung des Hinweises auf die Patenterteilung : 09.08.89 Patentblatt 89/32

(84) Benannte Vertragsstaaten :
DE FR GB IT NL

(56) Entgegenhaltungen :
EP-A- 0 073 452
EP-A- 0 092 486
DE-A- 3 035 167
DE-A- 3 238 487
DE-B- 2 263 177
US-A- 4 386 347

(73) Patentinhaber : Asea Brown Boveri Aktiengesellschaft
Kallstadter Strasse 1
D-6800 Mannheim-Käfertal (DE)

(72) Erfinder : Heinze, Siegfried, Dipl.-Ing.
Neidsteiner Strasse 6
D-8500 Nürnberg (DE)
Erfinder : Haussel, Werner
Ahornstrasse 51
D-8501 Feucht (DE)
Erfinder : Kern, Reinhold
Jurastrasse 4
D-8430 Neumarkt (DE)
Erfinder : Roppelt, Günter
Rotbuchenstrasse 33
D-8500 Nürnberg (DE)

(74) Vertreter : Rupprecht, Klaus, Dipl.-Ing. et al
c/o Asea Brown Boveri Aktiengesellschaft Zentralbereich Patente Postfach 100351
D-6800 Mannheim 1 (DE)

## Beschreibung

Die Erfindung betrifft ein digitales Meßgerät der im Oberbegriff des Anspruchs 1 genannten Art.

Digitale Meßgeräte haben gegenüber analogen Meßgeräten den wesentlichen Vorteil, daß sich ihre Anzeigegenauigkeit nahezu beliebig erhöhen läßt. Zur Verbesserung der Anzeigegenauigkeit bedarf es nicht wie beim analogen Meßgerät einer Verlängerung der Skala, der durch die Größe des Meßgerätes enge Grenzen gesetzt sind, sondern die nummerische Anzeige muß lediglich durch eine oder mehrere Stellen erweitert werden. Vorteilhaft ist es auch, daß eine stehende nummerische Anzeige ohne Schwierigkeiten bis zur letzten Stelle abgelesen werden kann, während eine analoge Anzeige durch Parallaxenfehler oder falsche Bewertung der Skala in Bezug zum eingestellten Meßbereich leicht zu Ablesefehlern führt.

Den Vorteilen der nummerischen Anzeige stehen jedoch Nachteile gegenüber, sobald sich der Meßwert nicht statisch sondern dynamisch verhält. Meßwertänderungen führen zu einem ständigen Wechsel der nummerischen Anzeige, dem das Auge des Betrachters weder zur Erfassung des momentanen Absolutwertes noch der Änderungstendenz folgen kann. Diesbezüglich zeigt sich die Analoganzeige überlegen, bei der mit einem Blick die jeweilige Lage des Meßzeigers erfaßt werden kann und sowohl der grobe Absolutwert wie auch die Änderungstendenz sichtbar werden.

Es ist deshalb eine Vielzahl von Meßgeräten bekannt geworden, bei denen eine numerische Anzeige mit einer analogen Anzeige kombiniert ist, um die Vorteile beider Anzeigearten zu verbinden. Dabei hat es sich als zweckmäßig herausgestellt, die relativ empfindlichen elektromagnetischen Analogmeßwerke durch elektronische quasi analog anzeigende Displays zu ersetzen. Ein solches Display besteht aus mehreren, kettenförmig aneinandergereihten Leuchtdioden oder Flüssigkristallsegmenten, die, wie z. B. in der DE-B-21 41 361 beschrieben, über eine elektronische Schaltung einzeln ansteuerbar sind. Flüssigkristalle werden nicht nur wegen ihres geringen Leistungsbedarf bevorzugt, sondern haben auch den Vorteil, daß die einzeln ansteuerbaren Flächensegmente in ihrer Form nahezu beliebig an den jeweiligen Anwendungsfall anpaßbar sind.

Zur Nachbildung einer bestimmten Zeigerstellung wird jeweils das Flächensegment eines Flüssigkristall-Displays angesteuert, dessen Lage der zu simulierenden Zeigerstellung am nächsten kommt. Wird nicht nur dieses eine Flächensegment sondern werden alle davorliegenden Flächensegmente angesteuert, so spricht man von einer Balkenanzeige oder Bandanzeige, die den Meßwert auch aus größerer Entfernung noch erkennbar werden läßt.

Ein mit einem Flüssigkristall-Display ausgestatteter Tachometer ist in der EP-A-0 092 486 beschrieben. Bei diesem Gerät ist eine Umschaltung zwischen zwei Meßbereichen vorgesehen. Der erste Meßbereich reicht von 0 bis 160 km/h, während der zweite Meßbereich nur von 0 bis 80 km/h reicht und erzielt dementsprechend eine doppelt so große Auflösung. Hierbei handelt es sich allerdings nicht um eine Spreizung durch Bildung eines Meßbereichsausschnittes und die Umschaltung des Meßbereichsausschnittes, sondern um eine ganz normale Meßbereichsumschaltung zwischen Meßbereichen mit verschiedenem Meßumfang.

Demgegenüber ist aus der DE-A-32 38 487 ein digitales Meßgerät bekannt, das ebenfalls ein Flüssigkristall-Display zur quasi analogen Anzeige besitzt, jedoch zusätzlich durch die gespreizte Darstellung eines Teilbereiches die Ablesegenauigkeit verbessert. Da die Spreizung im Bereich eines vorzugsweise in Skalenmitte angeordneten Sollwertes erfolgt, ist auch bei kleinen Meßwertänderungen gut erkennbar, ob sich der Meßwert dem Sollwert nähert.

Das bekannte Meßgerät ist bezüglich seines gespreizten Meßbereichsausschnittes auf einen Sollwert fixiert und somit für normale, sollwertunabhängige Messungen nicht geeignet. Hinzu kommt, daß der Meßwert nicht in Absolutwerten abgelesen werden kann, sondern als prozentuale Abweichung dargestellt ist. Nachteilig ist weiterhin, daß nur ein gespreizter Meßbereichsausschnitt vorgesehen ist. Dieser kann jedoch entweder zu schwach gespreizt sein, so daß die Auflösung zur Beobachtung der Meßwertänderung nicht ausreicht oder aber so stark gespreizt sein, daß der Meßwert außerhalb des Meßbereichsausschnittes zu liegen kommt.

Weiterhin ist aus der DE-A1-30 35 167 ein Meßgerät mit einer Digitalanzeige und einer analogen Anzeigeskala bekannt, bei dem die Anzeige des Sollwertes eines zu überwachenden Prozeßparameters auf einen vorbestimmten Skalenpunkt, vorzugsweise den Skalenmittelpunkt, einstellbar ist. Die Anzeige des Meßwertes erfolgt durch ein entlang einer ebenen Anzeigeskala mechanisch geführtes Band. Es sind außerdem Mittel vorgesehen, die die Anzeige des Mittelwertes im Bereich des Sollwertes spreizen. So kann die Spreizung optisch mit Hilfe einer Lupe erfolgen oder auch durch entsprechende Verstärkung des Meßsignals herbeigeführt werden. In letzterem Fall ist ein Ablesen des Meßwertes auf der zughörigen Skala nicht mehr möglich, was durch ein entsprechendes Signalelement signalisiert wird. Das bekannte Meßgerät ist zwar als Meßregler nicht jedoch für übliche Messungen, wie sie z. B. bei Vielfachmeßgeräten ausgeführt werden, geeignet.

Aufgabe der Erfindung ist es, ein digitales Meßgerät der im Oberbegriff des Anspruchs 1 genannten Art zu schaffen, das Tendenzbeobachtungen sowohl sehr kleiner, als auch großer Meßwertänderungen sowie ein analoges Ablesen des Meßwertes innerhalb des jeweils gewählten ganzen Meßbereiches erlaubt.

Diese Aufgabe wird durch die im Anspruch 1 gekennzeichneten Merkmale gelöst. Vorteilhafte Ausgestaltungen und Weiterbildungen des Erfindungsgegenstandes sind in den Unteransprüchen genannt.

Die Erfindung gestattet es, auch sehr kleine Meßwertänderungen durch eine entsprechende Spreizung des Meßbereichsausschnittes gut sichtbar zu machen andererseits aber auch große Meßwertänderungen, die zu einer Überschreitung mehrerer Meßbereichsausschnitte führen, nicht nur in ihrer Tendenz sondern auch in ihrem Wert auf der Analogskala zu erfassen.

In der weiteren Ausgestaltung des Erfindungsgedankens können zwei Alternativen zur Anwendung kommen. Bei der ersten Alternative wären der Meßbereichsausschnitt und der Gesamtmeßbereich auf zwei parallel liegenden Skalen anzuordnen. In weiterer Ausgestaltung dieser Ausführungsform könnte man parallel zur Skala für den Gesamtmeßbereich einen Cursor plazieren, dessen veränderbare Lage und dessen Breite den auf der zweiten Skala sichtbar gemachten gespreizten Meßbereichsausschnitt kennzeichnet.

Die zweite Alternative besteht darin, beide Meßbereiche auf einer gemeinsamen Skala anzuordnen. Der gespreizte Meßbereichsausschnitt kommt hierbei im mittleren Teil der Skala zu liegen während einseitig bzw. im Normalfall beidseitig sich an den Meßbereichsausschnitt der Anfang und/oder das Ende des Gesamtmeßbereiches anschließt. Nimmt der gespreizte Meßbereichsausschnitt den größten Teil der Skala in Anspruch, so müssen die über ihn hinausgehenden Teile des Gesamtmeßbereiches entsprechend gedrängt werden. Diese Alternative hat gegenüber der erstgenannten den Vorteil, daß nicht zwei Skalen beobachtet werden müssen, sondern die jeweilige Anzeige mit einem Blick erfaßt werden kann.

Bezüglich seiner elektronischen Schaltung ist ein solches Meßgerät derart aufgebaut, daß eine Meßwerteingabeeinheit vorgesehen ist, die zur Anpassung des Meßwertes dient und deren Ausgangssignal einerseits zur Erfassung der Bereichsparameter direkt und andererseits über eine Anpaßschaltung und einen AD-Wandler einem Mikrocomputer zugeführt ist. Der Mikrocomputer wirkt als Steuerautomatik und sorgt für eine Umsetzung des Meßwertes in einzelne zur Aktivierung der Flächensegmente des Displays erforderliche Steuersignale, die er über einen Anzeigentreiber diesen zuführt. Über eine Bedienungseinheit werden dem Mikrocomputer Parameter wie Betriebsmodus, Meßbereich, Faktor für die Spreizung des Meßbereichsausschnittes und weitere die Ansteuerung der Flächensegmente bestimmende Kriterien vorgegeben.

Um den gespreizten Meßbereichsausschnitt möglichst optimal an die jeweilige Meßaufgabe anpassen zu können, ist es vorteilhaft, wenn der Spreizungsfaktor einstellbar ist, wobei die Einstellung stetig durch ein Potentiometer und/oder stufig durch einen Schalter erfolgen kann. Der Meßbereichsausschnitt soll jeweils den Teil des Gesamtmeßbereiches erfassen, in dem sich der Meßwert befindet. Gemäß der Erfindung erfolgt eine Nachführung des Meßbereichsausschnittes bei sich änderndem Meßwert derart, daß der Meßwert ein Schaltsignal auslöst, wenn er den Meßbereichsausschnitt überschreitet und das Schaltsignal die Steuerautomatik aktiviert, die den benötigten richtigen Meßbereichsausschnitt auswählt.

Die Auswahl des richtigen Meßbereichsausschnittes kann zweckmäßiger Weise so vorgenommen werden, daß die Steuerautomatik den vorgewählten Spreizungsfaktor und den momentanen Meßwert ermittelt und entsprechend diesem den Meßbereichsausschnitt so auswählt, daß der momentane Meßwert möglichst nahe der Skalenmitte zu liegen kommt. Hierdurch ergibt sich eine Überschneidung zweier aufeinanderfolgender Meßbereichsausschnitte, die etwa einem halben Meßbereichsausschnitt entspricht. Die Überschneidung sorgt dafür, daß ein im Grenzbereich des Meßbereichsausschnittes pendelnder Meßwert nicht auch zu einem Pendeln der Umschaltung zwischen zwei Meßbereichsausschnitten führt. Die Umschaltung erfolgt also nicht vom Ende eines Meßbereichsausschnittes auf den Anfang des nächsten, sondern so, daß die Anzeige etwa in die Mitte der Skala fällt.

Unterstützt werden kann die vorbeschriebene Maßnahme noch dadurch, daß die Umschaltung nicht spontan erfolgt, sobalt der Meßwert den oberen oder unteren Grenzwert des Meßbereichsausschnittes erreicht, sondern erst dann, wenn er einen der beiden Grenzwerte bereits eine bestimmte, vorgebbare Zeit überschritten hat.

Die Vorteile der Erfindung kommen nicht nur bei unbeeinflußbaren Meßwertänderungen zum Tragen, sondern selbstverständlich auch dort, wo der Meßwert z. B. durch einen Abgleich beeinflußt wird. Hierzu ist es zweckmäßig, einen Referenzwert innerhalb des durch den Meßbereichsausschnitt belegten Skalenteils, vorzugsweise in Skalenmitte, zu positionieren. Zum Setzen des Referenzwertes sind Eingabetasten vorgesehen und das Unter- oder Überschreiten des Grenzwertes wird durch ein akustisches und/oder optisches Signal angezeigt.

Zur Überprüfung des Toleranzbereiches von elektrischen Bauelementen, insbesondere Widerständen, arbeitet man vorteilhaft mit einem Grenzwertbereich. Das digitale Meßgerät ist in weiterer Ausgestaltung so ausgebildet, daß beidseitig zu einem in Skalenmitte positionierten Referenzwert ein Grenzwertbereich gebildet ist, dessen Anfang und Ende vorzugsweise durch den Anfangs- und Endwert des Meßbereichsausschnittes festgelegt wird, was durch die Wahl des Spreizungsfaktors erfolgen kann.

Über- bzw. Unterschreitungen des Grenzbereiches werden zur besseren Unterscheidung vorzugsweise durch unterschiedliche akustische und/oder optische Signale angezeigt. Das Ablesen der Abweichung des Meßwertes vom Grenzwert läßt sich dadurch verbessern, daß der Grenzwertbereich als Plus/Minus-Toleranzbereich mit Prozent- oder Absolutwertangabe dargestellt ist.

Es ist zweckmäßig, den Zeitschalter, der zum Einstellen der Verzögerungszeit für das Umschalten des Meßbereichsausschnittes dient, mit weiteren Schaltpositionen zum Einschalten eines oder mehrerer Referenzwerte zu versehen. Ein weiterer Schalter dient zum Einschalten eines akkustischen Signals für die Grenzwertüberwachung.

Zur Darstellung der Skala mit Beschriftung und der Zeigermarke auf einem Display, kann dieses recht unterschiedlich ausgebildet sein. Man verwendet normalerweise Flüssigkristalle, die in eine Vielzahl einzelner Flächensegmente unterteilt sind und z. B. über eine Matrix angesteuert werden können. Alle Flächensegmente sind hierbei gleich groß und etwa punktförmig ausgebildet. Eine solche Matrixsteuertechnik hat den Vorteil, daß praktisch beliebige Bilder dargestellt werden können, deren Qualität lediglich durch die Auflösung des Punktrasters begrenzt ist. Nachteilig ist allerdings der hohe Schaltungsaufwand für die Ansteuermimik und der komplizierte Aufbau des Displays. Eine wesentliche Vereinfachung läßt sich dadurch erzielen, daß die Flächensegmente des Displays in ihrer Form an die vorgegebenen Skalenvarianten angepaßt sind und bezüglich ihrer Flächenausdehnung teilweise sehr unterschiedlich ausgebildet werden. Die Zahl der anzusteuernden Flächensegmente kann hierdurch erheblich reduziert werden. Gleichzeitig ist es möglich im Vergleich zur Matrixsteuertechnik mit erheblich niedrigerer Multiplexrate zu arbeiten und trotzdem mit weniger Zuführungsleitungen auszukommen.

Eine weitere Vereinfachung der Steuermimik ist dadurch erreichbar, daß die Skala eine feste Skalenteilung besitzt, die unabhängig vom gewählten Gesamtmeßbereich und dem jeweiligen Meßbereichsausschnitt gleichbleibt. Nur die Länge der Skalenstriche und die Beschriftung der Skalen unterliegt einer Änderung zur Anpassung an den jeweiligen Meßbereich. Die invariablen Teile der Skala können dabei gemeinsam angesteuert oder durch Aufdruck fest vorgegeben werden.

Wenn die Skalenteilung fest vorgegeben ist, muß die Zahl der Skalenstriche so gewählt werden, daß die Skala leicht an den jeweiligen Meßbereich angepaßt werden kann. So wird eine Skala, die für einen Gesamtmeßbereich vorgesehen ist, dessen Endwert ein dekadisches Vielfaches von drei ist, mit dreizehn Skalenstrichen versehen. Von dieser Skala wird der erste und der letzte Strich unsichtbar geschaltet, wenn ein Gesamtmeßbereich mit einem Endwert darzustellen ist, der ein dekadisches Vielfaches von eins, zwei, vier oder fünf bei einem Spreizungsfaktor von 1 beträgt. Zur Darstellung des Meßbereichsausschnitts dienen jeweils nur elf Skalenstriche, von denen der sechste in Skalenmitte liegt und die von zwei den Gesamtmeßbereich begrenzenden äußeren Skalenstrichen eingeschlossen sind. Für den Endwert des Meßbereichsausschnittes wird unabhängig vom eingestellten Spreizungsfaktor ebenso dekadisches Vielfaches von eins, zwei, vier oder fünf genommen.

Die zur Darstellung der Zeigermarke ansteuerbaren Flächensegmente liegen in gleichem Abstand parallel nebeneinander vom Skalenanfang bis zum Skalenende. Die Zahl und Position dieser Flächensegmente ist so gewählt, daß an jedem Teilungsstrich der Skala ein Flächensegment für die Zeigermarke zu liegen kommt und weitere Flächensegmente zwischen den Teilungsstrichen angeordnet sind. Zur besseren Ablesbarkeit ist sowohl im Meßbereichsausschnitt, wie auch in dem ihn einschließenden Gesamtmeßbereich eine lineare Teilung für die Sprünge der Zeigermarke vorgesehen. Dabei handelt es sich jedoch im Bereich des Meßbereichsausschnitts um eine lineare Spreizung und außerhalb seiner Grenzen um eine lineare Drängung. Das Überschreiten des Gesamtmeßbereiches wird durch eine Überlaufmarke signalisiert.

Damit der Schaltungsaufwand für die Ansteuerung des Displays in Grenzen gehalten wird, werden nur der Anfangs- und Endwert des Meßbereichsausschnittes sowie des Gesamtmeßbereichs und im allgemeinen auch der Skalenmittelwert durch den Meßbereich kennzeichnende alphanummerische Zeichen angezeigt. Zur Anzeige des momentanen Meßwertes also des Istwertes, dient zusätzlich eine flächenmäßig wesentlich größere Ziffernanzeige oberhalb oder unterhalb der Skala.

Eine fest vorgegebene Skala mit variabler Länge der Skalenstriche vorausgesetzt, benötigt eine Skalenanpaßautomatik, die dafür sorgt, daß bei einer Umschaltung des Meßbereiches die längeren Skalenstriche an einer Stelle zu liegen kommen, die eine leicht lesbar Unterteilung des eingestellten Meßbereiches gewährleistet. Die Skalenanpaßautomatik sorgt weiterhin dafür, daß nach einer Grobeinstellung des Spreizungsfaktors von Hand oder einer automatischen Einstellung in Abhängigkeit von bestimmten Parametern eine Feineinstellung derart erfolgt, daß der zur Darstellung kommende Meßbereichsausschnitt zu der fest vorgegebenen Skalenteilung paßt.

Die Anpassung der Skalenteilung und -beschriftung an den jeweiligen Meßbereich führt zu einer wesentlichen Vereinfachung der Meßwertablesung. Denn es muß nun nicht mehr eine von mehreren Skalen des Vielfachmeßgerätes nach Meßbereich und Meßgröße richtig zugeordnet und bewertet werden. Unabhängig von Zahl und Art der Meßbereiche und Meßgrößen kommt jeweils nur eine Skala zur Anzeige und diese besitzt eine so ausgelegte Skalenteilung, daß in jedem Fall eine optimale Ablesbarkeit gewährleistet ist.

Ein Ausführungsbeispiel der Erfindung wird im folgenden näher beschrieben und ist in den Zeichnungen dargestellt.

Es zeigen :

Figur 1 : Eine Draufsicht auf das Display und die Bedienungselemente eines Vielfachmeßgerätes.

Figur 2 : Einen Ausschnitt aus dem Display, auf dem eine Skala für den Gesamtmeßbereich und eine für den Meßbereichsausschnitt dargestellt sind.

Figur 3 : Die Darstellung von drei Skalen, die alle jeweils den Gesamtmeßbereich und einen Meßbereichsausschnitt auf einer gemeinsamen Skala darstellen, sich jedoch durch den jeweiligen Meßbereichsausschnit unterscheiden.

Figur 4 : Ein Blockschaltbild des Meßgerätes.

Figur 5 : Die Anordnung getrennt ansteuerbarer Flächensegmente zur Darstellung unterschiedlicher Skalenteilungen.

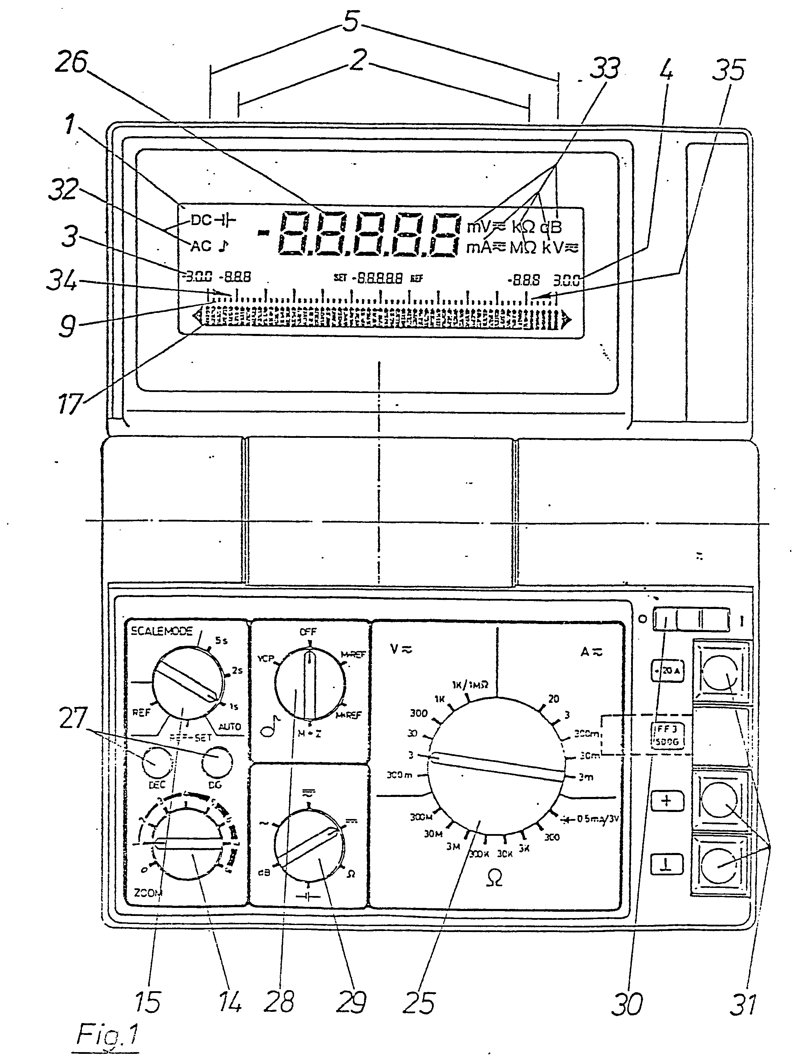

Das in Figur 1 dargestellte Vielfachmeßgerät besitzt ein aus Flüssigkristallen aufgebautes Display 1 zur Meßwertanzeige und mehrere Schalter und Taster zum Einstellen der verschiedenen, die Anzeige beeinflussenden Parameter. Auf dem Display wird der jeweilige Meßwert mit einer großflächigen Ziffernanzeige 26 und zusätzlich mit einer quasi analogen Skala 9 zur Anzeige gebracht.

Auf der Skala 9 ist ein Gesamtmeßbereich 5 und ein gespreizter Meßbereichsausschnitt 2 dargestellt. Die Skala 9 besitzt durchgehend eine lineare Skalenteilung, ungeachtet der Tatsache, daß sich für die Gesamtskala außerhalb des Meßbereichsausschnittes eine dessen Spreizung ausgleichende Drängung ergibt. Der gedrängte Bereich ist von dem gespreizten Bereich durch Dreieckmarken 34, 35 deutlich abgehoben. Hierdurch entsteht auch symbolisch der Eindruck einer zwischen den Spitzen der beiden Dreieckmarken 34, 35 liegenden Lupe, die zu einer gespreizten Darstellung des Meßbereichsausschnittes 2 führt.

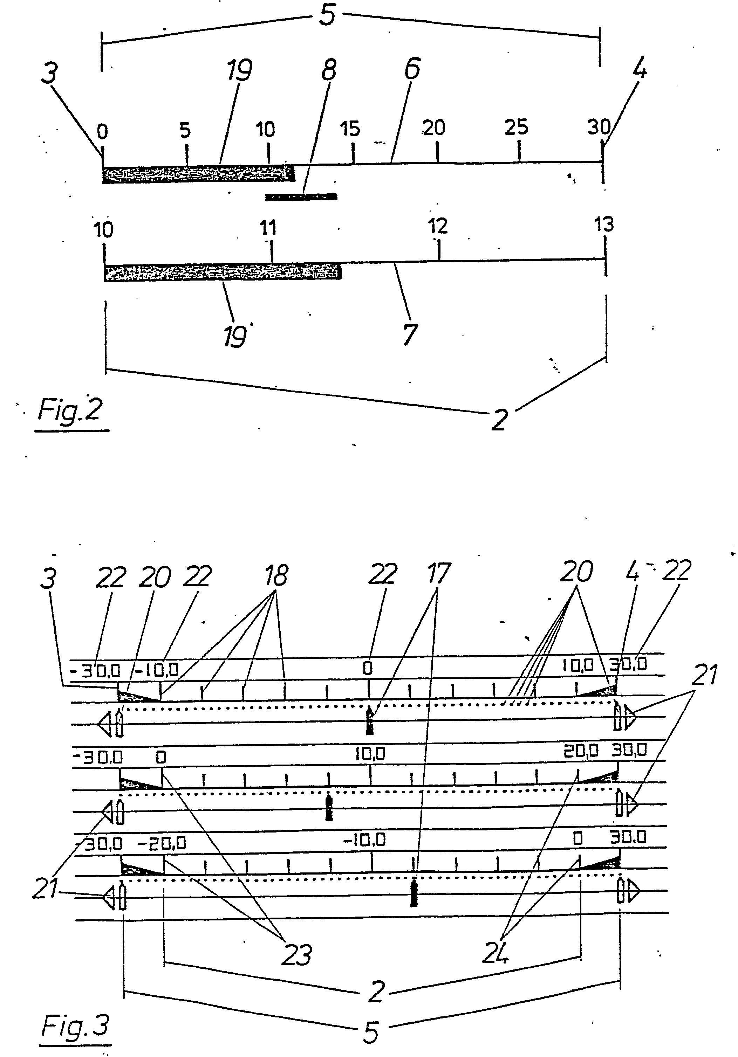

Wie besonders aus Figur 3 ersichtlich, sind unterhalb der Skala Flächensegmente 20 angeordnet, von denen jeweils das dem Meßwert am nächsten liegende angesteuert wird, wodurch ein sich scheinbar bewegender Zeiger entsteht. Selbstverständlich kann der Meßwert aber auch durch einen Anzeigebalken 19 angezeigt werden, wie das in Figur 2 dargestellt ist.

Bei dem Ausführungsbeispiel nach Figur 2 sind auf einem Display zwei Skalen 6, 7 parallel übereinander angeordnet, von denen die eine Skala 6 den Gesamtmeßbereich 5 und die andere Skala 7 einen Meßbereichsausschnitt 2 anzeigt. Sowohl zur Auswahl, wie auch zur Sichtbarmachung des Meßbereichsausschnittes 2 ist parallel zur Skala 6 für den Gesamtmeßbereich 5 ein Cursor 8 eingeblendet, dessen Lage und Breite den Meßbereichsausschnitt 2 definiert.

Durch die in Figur 3 dargestellte Zusammenfassung von Gesamtmeßbereich 5 und Meßbereichsausschnitt 2 auf einer gemeinsamen Skala, reduziert sich der Aufwand für die Ansteuermimik ganz beträchtlich. Zudem kann man die Gesamtanzeige auf einen Blick übersehen, ohne daß das Auge von einer Skala zur anderen wechseln muß. Der Meßbereichsausschnitt 2 ist jeweils so angeordnet, daß sein mittlerer Wert etwa in Skalenmitte zu liegen kommt. Dieser mittlere Wert erreicht nach Figur 3 bei der ersten Skala, deren Meßbereichsausschnitt zwischen — 10,0 und + 10,0 liegt, einen Wert von 0, bei der zweiten Skala deren Meßbereichsausschnitt zwischen 0 und + 20,0 liegt, einen Wert von 10,0 und bei der dritten Skala deren Meßbereichsausschnitt zwischen — 20,0 und 0 liegt einen Wert von — 10,0. Um den Steueraufwand klein zu halten, werden maximal fünf Skalenwerte in Ziffern 22 angezeigt. Hierzu gehören der Skalenanfangswert 3 und der Skalenendwert 4 des Gesamtmeßbereiches 5, der Skalenanfangswert 23 und der Skalenendwert 24 des Meßbereichsausschnittes 2 sowie der mittlere Skalenwert.

Die Skala besitzt eine feste Skalenteilung, mit nur 13 auf den Gesamtmeßbereich entfallenden Skalenstrichen. Diese Skalenstrichanzahl ist besonders günstig für Skalen mit einer Dreierteilung. Bei dem vorliegenden Beispiel erfordern die meisten Meßbereiche eine Umschaltung in Dreierdekaden. Nimmt man zunächst an, für den Meßbereichsausschnitt sei ein Spreizungsfaktor von 1 gewählt, so gilt die Dreierteilung durchgehend für den gesamten Meßbereich. Eine Trennung zwischen Gesamtmeßbereich und Meßbereichsausschnitt besteht in diesem Fall nicht und es werden auch die Dreieckmarken 34, 35 ausgeblendet.

Für den Meßbereichsausschnitt sind elf Teilstriche unabhängig vom jeweils gewählten Spreizungsfaktor vorgesehen. Die elf Teilstriche, von denen der sechste in Skalenmitte liegt, sind besonders gut für einen Endwert von eins, zwei, vier oder fünf geeignet. Soll ein solcher Endwert bei einem Gesamtmeßbereich realisiert werden, so wird die Gesamtskala auf elf Teilstriche, durch Ausblenden des ersten und letzten der dreizehn Teilstriche, beschränkt, sofern ein Spreizungsfaktor von eins vorgesehen ist. Bei größeren Spreizungsfaktoren können auch bei einer einser, zweier, vierer oder fünfer Teilung dreizehn Teilstriche verwendet werden.

Auf die dreizehn Teilstriche der Skala entfallen einundsechzig Flächensegmente 20, die jeweils die Stellung des Meßwertzeigers markieren können. Bezogen auf die elf Teilstriche des Meßbereichsausschnittes sind es noch einundfünfzig Flächensegmente 20 für die Zeigerstellung.

Insbesondere für Abgleichaufgaben ist es sehr vorteilhaft, wenn ein beliebiger Referenzwert in Skalenmitte vorgegeben werden kann, auf den dann der Meßwert einzustellen ist. Da es sich bei einem solchen Referenzwert um einen « krummen » Wert mit mehreren Stellen hinter dem Komma handeln kann, würde dieser mit der fest vorgegebenen Skalenteilung kollidieren. Bei in Skalenmitte vorgegebenen Referenzwerten wird deshalb der Meßbereichsausschnitt nicht mit Skalennennwerten versehen, sondern mit Plus/Minus-Werten, die sich auf den Referenzwert beziehen und an die Skalenteilung angepaßt werden können.

Besonderheiten für die Displayansteuerung können sich im Übergangsbereich vom Meßbereichsausschnitt zum Gesamtmeßbereich ergeben. Fällt der Anfangs- oder Endwert des Gesamtmeßbereiches mit dem Anfangs- oder Endwert des Meßbereichsausschnittes zusammen, dann wird der jeweils gleiche Wert des Gesamtmeßbereiches ausgeblendet und die Skala verkürzt sich um einen Teilstrich. Wird, insbesondere durch entsprechende Referenzwertvorgabe, ein Meßbereichsausschnitt gewählt, der teilweise über die Grenzen des Gesamtmeßbereiches hinausgeht, so springt die Meßwertanzeige zunächst auf den Endwert des Gesamtmeßbereiches und dann zur Überlaufmarke 21.

Wie Figur 1 zeigt, ist die Spreizung des Meßbereichsausschnittes durch einen Zoom-Schalter 14 einstellbar. Dabei entspricht die Zoom-Stellung 0 einem Spreizungsfaktor von 1. Zum Auffinden des Meßbereichsausschnittes, in dem gerade der Meßwert liegt, ist eine Steuerautomatik vorgesehen. Diese verfolgt den Meßwert und bringt bei vorgegebenem Spreizungsfaktor jeweils den Meßbereichsausschnitt zur Anzeigen bei dem der momentane Meßwert etwa in die Skalenmitte fällt. Bei einer fortlaufenden Umschaltung des Meßbereichsausschnittes, z. B. bei stetig steigendem Meßwert, wird also nicht vom Skalenende auf den Skalenanfang des nächsten Meßbereichsausschnittes, sondern auf dessen Mitte, also nur um einen halben Meßbereichsausschnitt, weitergeschaltet.

Eine zusätzliche Maßnahme zur Verhinderung eines unerwünschten Hin- und Herschaltens zwischen zwei benachbarten Meßbereichsausschnitten bei pendelndem Meßwert besteht darin, daß ein Zeitschalter 15 vorgesehen ist. Mit diesem läßt sich eine Zeit einstellen, durch die das Umschalten des Meßbereichsausschnittes verzögert wird. Es wird dann quasi abgewartet, ob der Meßwert nicht wieder in die Ausgangsposition zurückkehrt, bevor die Umschaltung erfolgt.

Der Zeitschalter 15 ist in Figur 1 als Scalemode deklariert, weil er noch zusätzliche Schaltstellungen für die Vorgabe und das Einstellen eines Referenzwertes besitzt. Das Einstellen erfolgt bei « Ref. Set. » durch einen Referenzwert-Eingabetaster 27. Ein Meßbereichs- und Meßgrößenumschalter 25 ist mit einem Meßartenschalter 29 kombiniert, der auch eine Überprüfung der Batteriespannung erlaubt.

Ein akustisches Signal läßt sich durch den Signalschalter 28 vorgeben. Es wird je nach Schalterstellung ausgelöst, wenn der Meßwert größer oder kleiner ist als der eingestellte Referenzwert oder ermöglicht in der Stellung « VCP » eine Frequenz- bzw. Impulsänderung, durch die eine Annäherung des Meßwertes an den eingestellten Referenzwert oder auch die Änderung des absoluten Meßwertes akustisch verdeutlicht wird. Zum Einschalten des Meßgerätes dient der Einschalter 30 und zum Anschließen der Meßleitungen Anschlußbuchsen 31.

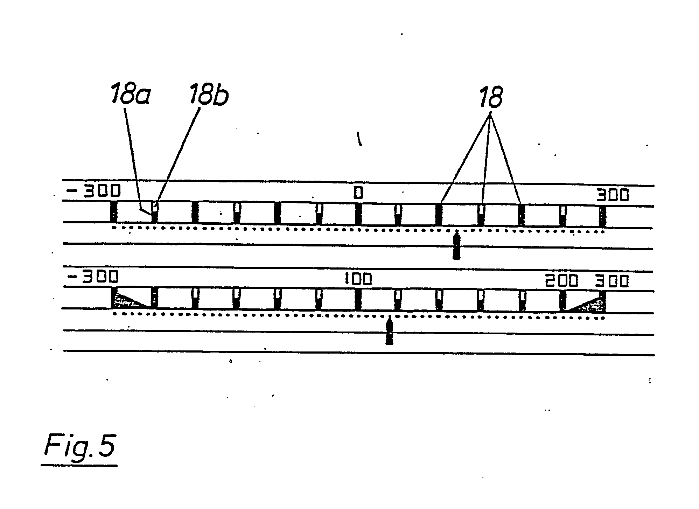

Da die Kosten des Meßgerätes wesentlich von dem erforderlichen Aufwand für die Ansteuerung des Displays abhängt, ist die Zahl der einzeln ansteuerbaren Flächensegmente auf das notwendige Minimum reduziert. Hierzu ist die Skala in ihrem Grundaufbau fest vorgegeben. Wie Figur 5 zeigt, kann aber die Länge der Skalenstriche 18 und damit begrenzt auch die Skalenaufteilung beeinflußt werden. Die Skalenstriche bestehen hierzu aus zwei getrennten Flächensegmenten 18a, 18b. Während alle Flächensegmente 18a gemeinsam angesteuert werden, können die Flächensegmente 18b einzeln der gewünschten Skalenteilung entsprechend zur Anzeige gebracht werden.

Bei einem mit dem Zoom-Schalter 14 vorgewählten Spreizungsfaktor paßt die Spreizung der Meßbereichsausschnitte im allgemeinen nicht unmittelbar mit der vorgegebenen Skalenteilung zusammen. Eine Skalenanpaßautomatik sorgt deshalb dafür, daß durch eine Feinabstimmung des Spreizungsfaktors eine Anpassung an die Skala erfolgt.

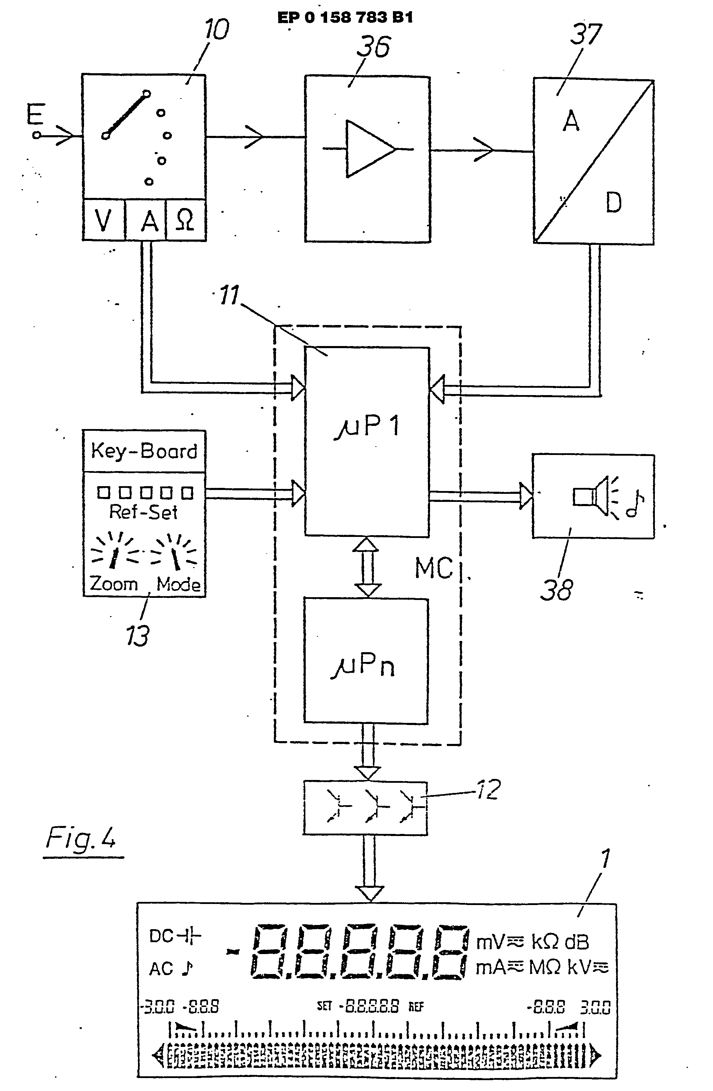

Das Meßgerät besitzt, wie Figur 4 zeigt, einen Mikrocomputer 11 mit mindestens einem Mikroprozessor, der die von der Meßeingabeeinheit 10 kommenden Meßdaten in Verbindung mit den an der Bedienungseinheit 13 vorgegebenen Parametern, insbesondere für die Skalen- und die Referenzwerte, bewertet und umrechnet und die aufbereiteten Meßdaten über einen Anzeigentreiber 12 dem Display 1 als Steuersignale zuführt. Die Datenaufnahme des Mikrocomputers erfolgt einerseits unmittelbar von der Meßwerteingabeeinheit und andererseits nach Umsetzung der von der Meßwerteingabeeinheit kommenden Signale in einem Buffer und Effektivwertwandler 36 sowie einem nachgeschalteten A/D-Wandler 37. Zur akustischen Signalabgabe besitzt der Mikrocomputer noch einen Ausgang für einen Referenz-Piper 38.

Zur Erläuterung der auf dem Display dargestellten Zeichen ist noch darauf hinzuweisen, daß alle Flächensegmente, die insgesamt ansteuerbar sind, in Fig. 1 und Fig. 4 dargestellt sind. Da die Zeichen auf dem Display nicht durch eine Matrixsteuerung sondern durch Ansteuerung einzelner den jeweiligen Zeichen entsprechende Flächensegmente erfolgt, können die Zeichen nicht wahlweise übereinander, an der selben Stelle, sondern nur wahlweise nebeneinander sichtbar gemacht werden. Im praktischen Betrieb werden selbstverständlich von den dargestellten Zeichen für die Stromartenanzeige 32 und für die Meßgrößenanzeige 33 jeweils nur eines eingeblendet. Entsprechendes gilt auch für die Ziffern 22, 26 die bei einer Ansteuerung aller sieben Segmente jeweils eine acht ergeben und für die Zeigermarken 17, von denen nur eine einzeln oder mehrere als Band angesteuert werden.

## Patentansprüche

1. Digitales Meßgerät zur quasi analogen Anzeige des Meßwertes mit einem Display (1), auf dem eine Meßwertskala (6, 7, 9) mit Beschriftung (22, 32, 33) und eine durch ansteuerbare Flächensegmente (20) ihre Stellung ändernde Zeigermarke (17) oder Balkenanzeige (19) vorgesehen ist und die Meßwertskala (6, 7, 9) aus einem vorgegebenen Gesamtmeßbereich einen gespreizten Meßbereichsausschnitt (2) wiedergibt, dadurch gekennzeichnet, daß auf dem Display (1) außer der Skala für den Meßbereichsausschnitt (2) auch eine den zwischen Meßbereichsanfang (3) und Meßbereichsende (4) liegenden Gesamtmeßbereich (5) kennzeichnende Skala dargestellt ist und der Meßwert bei beiden Skalen durch die Ansteuerung der die quasi analoge Meßwertanzeige vermittelnden Flächensegmente (20) angezeigt ist und daß eine Steuerautomatik (11) beim Umschalten des Meßbereichsausschnittes (2) mit Hilfe weiterer ansteuerbarer Flächensegmente die Beschriftung (22, 32, 33) des Meßbereichsausschnittes (2) so ändert, daß seine jeweilige Lage innerhalb des Gesamtmeßbereiches (5) definiert ist und die Umschaltung derart erfolgt, daß der Meßwert ein Schaltsignal auslöst, wenn er bestimmte Grenzen des innerhalb des Gesamtmeßbereiches (5) liegenden Meßbereichsausschnittes (2) überschreitet und das Schaltsignal die Steuerautomatik (11) aktiviert und diese den zur Anzeige des Meßwertes richtigen Meßbereichsausschnitt (2) auswählt.

2. Digitales Meßgerät nach Anspruch 1, dadurch gekennzeichnet, daß beide Skalen (2, 5) nebeneinander liegen und vorzugsweise etwa gleich groß sind.

3. Digitales Meßgerät nach Anspruch 2, dadurch gekennzeichnet, daß parallel zur Skala (6) für den Gesamtmeßbereich (5) ein Cursor (8) plaziert ist, dessen veränderbare Lage und dessen Breite den auf der zweiten Skala (7) sichtbaren gespreizten Meßbereichsausschnitt (2) kennzeichnet.

4. Digitales Meßgerät nach Anspruch 1, dadurch gekennzeichnet, daß die Skalen für beide Meßbereiche (2, 5) auf eine gemeinsame Skala (9) fallen, wobei der gespreizte Meßbereichsausschnitt (2) im mittleren Teil der Skala (9) zu liegen kommt und ein- oder beidseitig, sich an den Meßbereichsausschnitt (2) anschließend, Anfang und/oder Ende des gesamten Meßbereiches (5) angeordnet sind.

5. Digitales Meßgerät nach Anspruch 4, dadurch gekennzeichnet, daß die über den gespreizten Meßbereichsausschnitt (2) hinausgehenden Teile des gesamten Meßbereiches (5) gedrängt sind.

6. Digitales Meßgerät nach mindestens einem der vorhergehenden Ansprüche, dadurch gekennzeichnet, daß eine Meßwerteingabeeinheit (10) vorgesehen ist, die zur Anpassung des Meßwertes dient und deren Ausgangssignal einerseits zur Erfassung der Bereichsparameter unmittelbar und andererseits unter Zwischenschaltung einer Anpaßschaltung und eines AD-Wandlers einem Mikrocomputer (11) zugeführt ist, der als Steuerautomatik wirkt und die Umsetzung des Meßwertes in einzelne zur Aktivierung der Flächensegmente des Displays (1) erforderliche Steuersignale vornimmt und über einen Anzeigentreiber (12) diesen zuführt, wobei über eine Bedienungseinheit (13) dem Mikrocomputer (11) verschiedene den Meßbereich, die Spreizung des Meßbereichsausschnitts und weitere die Ansteuerung der Flächensegmente bestimmende Parameter vorgebbar sind.

7. Digitales Meßgerät nach mindestens einem der vorhergehenden Ansprüche, dadurch gekennzeichnet, daß der die Spreizung des Meßbereichsausschnitts (2) bestimmende Spreizungsfaktor einstellbar ist und zur stetigen Einstellung ein Potentiometer und/oder zur stufigen Einstellung ein Schalter (14) dient.

8. Digitales Meßgerät nach mindestens einem der vorhergehenden Ansprüche, dadurch gekennzeichnet, daß die Steuerautomatik die Auswahl des richtigen Meßbereichsausschnittes innerhalb des über einen Meßbereichsschalter eingestellten Meßbereiches derart vornimmt, daß sie den vorgewählten Spreizungsfaktor und den momentanen Meßwert ermittelt und entsprechend diesen den Meßbereichsausschnitt so auswählt, daß der momentane Meßwert möglichst nahe der Skalenmitte liegt.

9. Digitales Meßgerät nach mindestens einem der vorhergehenden Ansprüche, dadurch gekennzeichnet, daß ein Schalter (15) zum stufigen und/oder ein Potentiometer zum stetigen Einstellen einer Zeit für die verzögerte Auslösung des die Umschaltung des Meßbereichsausschnittes bewirkenden Schaltsignals dient.

10. Digitales Meßgerät nach mindestens einem der vorhergehenden Ansprüche, dadurch gekennzeichnet, daß durch Ansteuern entsprechender Flächensegmente mindestens ein Referenzwert innerhalb des durch den Meßbereichsausschnitt belegten Skalenteils, vorzugsweise in Skalenmitte, positioniert ist und zum Setzen des Referenzwertes Eingabetasten vorgesehen sind und das Unter- oder Überschreiten des Referenzwertes durch ein akustisches und/oder optisches Signal angezeigt wird.

11. Digitales Meßgerät nach mindestens einem der vorhergehenden Ansprüche, dadurch gekennzeichnet, daß beidseitig zu einem in Skalenmitte positionierten Referenzwert ein Grenzwertbereich gebildet ist, dessen Anfang und Ende vorzugsweise durch den Anfangs- und Endwert des Meßbereichsausschnittes festgelegt ist, und ein Überschreiten des Grenzwertbereiches nach unten oder oben durch vorzugsweise unterschiedliche Signale angezeigt wird.

12. Digitales Meßgerät nach Anspruch 11, dadurch gekennzeichnet, daß der Grenzwertbereich als Plus/Minus-Toleranzbereich mit Prozent- oder Absolutwertangabe dargestellt ist.

13. Digitales Meßgerät nach mindestens einem der vorhergehenden Ansprüche, dadurch gekennzeichnet, daß der Zeitschalter (15), der zum Einstellen der Verzögerungszeit für das Umschalten des Meßbereichsausschnittes (2) dient, weitere Schaltpositionen zum Einschalten eines oder mehrerer Referenzwerte besitzt und ein weiterer Schalter (16) zum Einschalten eines akustischen und/oder optischen Signals für die Grenzwertüberwachung vorgesehen ist.

14. Digitales Meßgerät nach mindestens einem der vorhergehenden Ansprüche, dadurch gekennzeichnet, daß die Flächensegmente des Displays über eine Matrix angesteuert sind und alle ansteuerbaren Flächensegmente eine gleich große etwa punktförmige Flächenausdehnung haben.

15. Digitales Meßgerät nach mindestens einem der Ansprüche 1 bis 13, dadurch gekennzeichnet, daß die Flächensegmente des Displays in ihrer Form an die vorgesehenen Skalenvarianten angepaßt sind, und bezüglich ihrer Flächenausdehnung teilweise sehr unterschiedlich sind und daß zum Ansteuern der Flächensegmente diese gegenüber einer gemeinsamen Elektrode einzeln an Gegenpotential gelegt sind, oder zur Reduzierung der einzeln anzusteuernden Elektroden bei Anwendung geeigneter Multiplexverfahren mehrere Gegenelektroden gebildet sind.

16. Digitales Meßgerät nach mindestens einem der vorhergehenden Ansprüche, dadurch gekennzeichnet, daß die Skala eine feste Skalenteilung besitzt, die unabhängig vom gewählten Gesamtmeßbereich (5) und dem jeweiligen Meßbereichsausschnitt (2) gleich bleibt und durch Änderung der Länge der Skalenstriche und der Skalenbeschriftung eine Anpassung erfolgt und die invariablen Teile der Skala gemeinsam angesteuert oder durch Aufdruck fest vorgegeben sind.

17. Digitales Meßgerät nach mindestens einem der vorhergehenden Ansprüche, dadurch gekennzeichnet, daß eine Skala, die für einen Gesamtmeßbereich vorgesehen ist, dessen Endwert ein dekadisches Vielfaches von drei ist, dreizehn Skalenstriche besitzt, von denen der erste und der letzte Strich unsichtbar geschaltet werden, wenn ein Gesamtmeßbereich mit einem Endwert darzustellen ist, der ein dekadisches Vielfaches von ein, zwei, vier oder fünf bei einem Spreizungsfaktor von 1 beträgt, während der Meßbereichsausschnitt jeweils elf Skalenstriche umfaßt, von denen der sechste Strich in Skalenmitte liegt.

18. Digitales Meßgerät nach mindestens einem der vorhergehenden Ansprüche, dadurch gekennzeichnet, daß die zur Darstellung der Zeigermarke (17) ansteuerbaren Flächensegmente (20) in gleichem Abstand parallel nebeneinander von Skalenanfang (3) bis zum Skalenende (4) angeordnet sind, und die Zahl und Position dieser Flächensegmente (20) so gewählt ist, daß an jedem Skalenstrich (18) ein Flächensegment (20) zu liegen kommt und weitere Flächensegmente (20) zwischen den Skalenstrichen (18) angeordnet sind.

19. Digitales Meßgerät nach mindestens einem der vorhergehenden Ansprüche, außer Anspruch 2 und 3, dadurch gekennzeichnet, daß eine lineare Spreizung innerhalb des Meßbereichsausschnittes (2) und eine lineare Drängung im außerhalb des Meßbereichsausschnittes (2) liegenden Gesamtmeßbereich (5) erfolgt, und ein Überschreiten des Gesamtmeßbereiches (5) durch eine Überlaufmarke (21) signalisiert ist.

20. Digitales Meßgerät nach mindestens einem der vorhergehenden Ansprüche, dadurch gekennzeichnet, daß Anfangs- und Endwert von Meßbereichsausschnitt und Gesamtmeßbereich sowie im allgemeinen auch der Skalenmittelwert in Ziffern (22) angezeigt sind, zur Anzeige des genauen Meßwertes (Istwertes) jedoch zusätzlich eine flächenmäßig wesentlich größere Ziffernanzeige (26) dient.

21. Digitales Meßgerät nach mindestens einem der vorhergehenden Ansprüche, dadurch gekennzeichnet, daß alle oder einige Skalenstriche (18) aus je zwei oder mehreren getrennt ansteuerbaren Strichsegmenten (18a, 18b) bestehen, die gemeinsam angesteuert die Länge des jeweiligen Skalenstriches vergrößern und eine Skalenanpaßautomatik (11) dafür sorgt, daß bei einer Umschaltung des Meßbereiches die längeren Skalenstriche an einer Stelle zu liegen kommen, die eine leicht lesbare Unterteilung des eingestellten Meßbereichs gewährleistet.

22. Digitales Meßgerät nach mindestens einem der vorhergehenden Ansprüche, dadurch gekennzeichnet, daß die Grobeinstellung des Spreizungsfaktors von Hand oder in Abhängigkeit von bestimmten Parametern automatisch vorgegeben wird, und die Skalenanpaßautomatik (11) die Feineinstellung des Spreizungsfaktors so vornimmt, daß der zur Darstellung kommende Meßbereichsausschnitt (2) zu der fest vorgegebenen Skalenteilung paßt.

23. Digitales Meßgerät nach mindestens einem der vorhergehenden Ansprüche, dadurch gekennzeichnet, daß die Flächensegmente zur quasi analogen Meßwertanzeige in kreis-, spiral-, wellenförmiger oder sonstiger dem jeweiligen Anwendungsfall entsprechender Anordnung auf dem Display aufgebracht sind.

24. Digitales Meßgerät nach mindestens einem der vorhergehenden Ansprüche, dadurch gekennzeichnet, daß die Ansteuerung der Teilstücke (18) und der Skalenwerte wahlweise so erfolgen kann, daß der Nullpunkt des Gesamtmeßbereiches und/oder Meßbereichsausschnittes am Anfang, in der Mitte oder am Ende der jeweiligen Skala liegt.

**Claims**

1. Digital measuring instrument for the quasi-analogue indication of the measured value, having a display (1), on which there is provided a measured value scale (6, 7, 9) with labelling (22, 32, 33) and a pointer mark (17) or bar display (19), which can be triggered by area segments (20) and changes its position, and the measured value scale (6, 7, 9) reproduces from a stipulated full measuring range an expanded measuring range segment (2), characterized in that, apart from the scale for the measuring range segment (2), there is also represented on the display (1) a scale identifying the full measuring range (5) lying between the start (3) and the end (4) of the measuring range, and, with regard to both scales, the measured value is indicated by the triggering of the area segments (20) conveying the quasi-analogue measured value display, and in that, at switch-over of the measuring range segment (2), an automatic controller (11), aided by further triggerable area segments, changes the labelling (22, 32, 33) of the measuring range segment (2) in such a way that its particular position within the full measuring range (5) is defined and the switching-over takes place in such a way that the measured value initiates a switching signal, if it overshoots specific limits of the measuring range segment (2) lying inside the full measuring range (5), and the switching signal activates the automatic controller (11), and the latter selects the measuring range segment (2) which is correct for diplaying the measured value.

2. Digital measuring instrument according to Claim 1, characterized in that the two scales (2, 5) lie next to each other and are preferably approximately of the same size.

3. Digital measuring instrument according to Claim 2, characterized in that there is placed parallel to the scale (6) for the full measuring range (5) a cursor (8), the changeable position and width of which characterizes the expanded measuring range segment (2) visible on the second scale (7).

4. Digital measuring instrument according to Claim 1, characterized in that the scales for both measuring ranges (2, 5) fall on a joint scale (9), the expanded measuring range segment (2) coming to lie in the central part of the scale (9) and start and/or end of the full measuring range (5) being arranged on one side or on both sides, adjoining the measuring range segment (2).

5. Digital measuring instrument according to Claim 4, characterized in that the parts of the full measuring range (5) going beyond the expanded measuring range segment (2) are contracted.

6. Digital measuring instrument according to at least one of the preceding claims, characterized in that a measured-value input unit (10) is provided, which serves to adapt the measured value, and whose output signal is fed to a microcomputer (11) directly, on the one hand, for the purpose of acquiring the range parameters, and with the insertion of an adapting circuit and an A/D converter, on the other hand, which microcomputer functions as automatic controller and undertakes the conversion of the measured value into individual control signals, which are necessary for activating the area segments of the display (1) and which it feeds to these segments via a display driver (12), it being possible to stipulate to the microcomputer (11) via an operating unit (13) various parameters determining the measuring range, the expansion of the measuring range segment and further parameters determining the triggering of the area segments.

7. Digital measuring instrument according to at least one of the preceding claims, characterized in that the expansion factor determining the expansion of the measuring range segment (2) can be set and a potentiometer serves for continuous setting and/or a switch (14) serves for stepwise setting.

8. Digital measuring instrument according to at least one of the preceding claims, characterized in that the automatic controller undertakes the selection of the correct measuring range segment inside the measuring range set by a measuring range switch in such a way that it determines the preselected expansion factor and the instantaneous measured value and, in accordance therewith, selects the measuring range segment so that the instantaneous measured value lies as near as possible to midscale.

9. Digital measuring instrument according to one of the preceding claims, characterized in that a switch (15) serves for stepwise and/or a potentiometer serves for continous setting of a time for the delayed initiation of the switching signal causing the switching-over of the measuring range segment.

10. Digital measuring instrument according to at least one of the preceding claims, characterized in that, by triggering appropriate area segments, at least one reference value is positioned inside the scale portion, preferably midscale, occupied by the measuring range segment, and input keys are provided to set the reference value and the undershooting or overshooting of the reference value is indicated by an acoustic and/or optical signal.

11. Digital measuring instrument according to at least one of the preceding claims, characterized in that a limiting value range is formed on both sides of a reference value positioned midscale, the start and end of which range is preferably established by the lower and upper range value of the measuring range segment and an overshooting of the limiting value range upwards or downwards is indicated by preferably different signals.

12. Digital measuring instrument according to Claim 11, characterized in that the limiting value range is represented as plus/minus tolerance band with indication of percentage or absolute values.

13. Digital measuring instrument according to at least one of the preceding claims, characterized in that the time switch (15), which serves to set the delay time for the switching-over of the measuring range segment (2), has further switching positions for switching-in one or more reference values, and a further switch (16) is provided for switching-in an acoustic and/or optical signal for the monitoring of limiting values.

14. Digital measuring instrument according to at least one of the preceding claims, characterized in that the area segments of the display are triggered via a matrix, an all triggerable area segments have an extent of area of the same size and approximately punctiform.

15. Digital measuring instrument according to at least one of the Claims 1 to 13, characterized in that the area segments of the display are adapted in their form to the scale variants provided, and are in part constructed very differently with regard to their extent of area, and in that, in order to trigger the area segments, the latter are connected individually to counter-potential with reference to a joint electrode, or a plurality of counter-electrodes are formed in order to reduce the electrodes to be individually triggered in the case of the application of suitable multiplex procedures.

16. Digital measuring instrument according to at least one of the preceding claims, characterized in that the scale has a fixed scale division, which remains the same independently of the chosen full measuring range (5) and of the particular measuring range segment (2), and an adaptation takes place through change in the length of the scale marks and of the scale labelling, and the invariable parts of the scale are triggered jointly or are firmly stipulated by imprinting.

17. Digital measuring instrument according to at least one of the preceding claims, characterized in that a scale, which is provided for a full measuring range, the upper range value of which is a decadic multiple of three, has thirteen scale marks, of which the first and the last mark are switched to invisible, if it is necessary to represent a full measuring range having an upper range value which amounts to a decadic multiple of one, two, four or five for an expansion factor of 1, while the measuring range segment comprises, in each case, eleven scale marks, of which the sixth mark lies midscale.

18. Digital measuring instrument according to one of the preceding claims, characterized in that the area segments which can be triggered to represent the pointer mark (17) lie at the same distance parallel to each other from the start of the scale (3) to the end of the scale (4), and the number and position of these area segments (20) is chosen so that an area segment (20) comes to lie at each scale mark (18) and further area segments (20) are arranged between the scale marks (18).

19. Digital measuring instrument according to at least one of the preceding claims, apart from Claim 2 and 3, characterized in that there takes place a linear expansion inside the measuring range segment (2) and a linear contraction in the full measuring range (5) lying outside the measuring range segment (2), and an overshooting of the full measuring range (5) is signalled by an overflow mark (21).

20. Digital measuring instrument according to at least one of the preceding claims, characterized in that lower range value and upper range value of measuring range segment and full measuring range, as well as, in general, also the scale average are displayed in digits (22), in addition, however, a digital display (26) of substantially greater area serves to indicate the exact measured value (actual value).

21. Digital measuring instrument according to at least one of the preceding claims, characterized in that all or some of the scale marks (18) consist, in each case, of two or several separably triggerable mark segments (18a, 18b), which, when triggered jointly, can increase the length of the particular scale mark, and an automatic scale adaptor (11) ensures that, upon switching-over the measuring range, the longer scale marks come to lie at a position which guarantees an easily readable subdivision of the set measuring range.

22. Digital measuring instrument according to at least one of the preceding claims, characterized in that the coarse setting of the expansion factor is stipulated by hand, or automatically as a function of specific parameters, and the automatic scale adaptor (11) undertakes the fine setting of the expansion factor in such a way that the measuring range segment (2) which comes to be represented is adapted to the firmly stipulated scale division.

23. Digital measuring instrument according to at least one of the preceding claims, characterized in that the area segments for quasi-analogue measured-value display are mounted on the display in a circular, spiral, waveshaped arrangement, or other arrangement corresponding to the particular application.

24. Digital measuring instrument according to at least one of the preceding claims, characterized in that the triggering of the sections (18) and of the scale values can take place alternatively in such a way that the zero point of the full measuring range and/or of the measuring range segment lies at the start, in the middle or at the end of the particular scale.

**Revendications**

1. Appareil de mesure numérique pour l'affichage quasi-analogique des valeurs mesurées, comprenant un écran de visualisation (1) sur lequel est prévue une échelle de mesure (6, 7, 9) avec légendes (22, 32, 33) et un index (17) ou un affichage à ruban (19) modifiant sa position au moyen de segments de surfaces commandés (20), et l'échelle de mesure (6, 7, 9) reproduisant un secteur élargi (2) d'une gamme de mesure complète prédéterminée, caractérisé par le fait que sur l'écran (1), en plus de l'échelle pour le secteur élargi (2), figure également une échelle caractérisant la gamme de mesure complète (5) située entre le début (3) et la fin (4) de la gamme de mesure, que la valeur mesurée des deux échelles est affichée par l'activation des segments de surfaces (20) déterminant l'affichage quasi-analogue des valeurs mesurées et qu'un dispositif de commande automatique (11), en cas de commutation du secteur élargi (2), modifie les légendes (22, 32, 33) du secteur (2) à l'aide d'autres segments de surface commandés de manière que la position à chaque fois considérée de celui-ci soit définie à l'intérieur de la gamme de mesure complète (5) et que la commutation s'effectue de telle sorte que la valeur mesurée enclenche un signal de commande lorsqu'elle dépasse des limites déterminées du secteur élargi (2) situé à l'intérieur de la gamme de mesure complète (b), que le signal de commande active le dispositif de commande automatique (11) et que celui-ci sélectionne le secteur élargi (2) convenant pour l'affichage de la valeur mesurée.

2. Appareil de mesure numérique selon la revendication 1, caractérisé par le fait que les deux échelles (2, 5) sont placées l'une à côté de l'autre et sont, de préférence, à peu près d'égale grandeur.

3. Appareil de mesure numérique selon la revendication 2, caractérisé par le fait que, parallèlement à l'échelle (6) pour la gamme de mesure complète (5), est placé un curseur (8) dont la position variable et la largeur désignent le secteur élargi (2) visible sur la seconde échelle (7).

4. Appareil de mesure numérique selon la revendication 1, caractérisé par le fait que les échelles pour les deux gammes de mesure (2, 5) se trouvent sur une échelle commune (9), le secteur élargi (2) étant situé dans la partie médiane de l'échelle (9) et le début et/ou la fin, se raccordant au secteur élargi (2), de la gamme de mesure complète (5), étant disposé d'un seul ou des deux côtés.

5. Appareil de mesure numérique selon la revendication 4, caractérisé par le fait que les parties de la gamme de mesure complète, dépassant le secteur élargi (2), comporte des divisions plus resserrées.

6. Appareil de mesure numérique selon au moins l'une des revendications précédentes, caractérisé par le fait qu'il est prévu une unité d'entrée (10) qui sert à l'adaptaton de la valeur mesurée et dont le signal de sortie, pour la saisie des paramètres des gammes, est appliqué d'une part directement pour l'enregistrement des paramètres des gammes et, d'autre part, indirectement, avec intercalation d'un circuit d'adaptation et d'un convertisseur analogique-numérique, à un micro-ordinateur (11) qui fait office de dispositif de commande automatique et effectue la conversion de la valeur mesurée en différents signaux de commande nécessaires à l'activation des segments de surface de l'écran de visualisation (1) et les délivre à ceux-ci par l'intermédiaire d'un étage excitateur (12), différents paramètres, déterminant la gamme de mesure, l'élargissement du secteur de la gamme de mesure et l'activation des segments de surfaces, étant envoyés au micro-ordinateur (11) par une unité de manœuvre (13).

7. Appareil de mesure numérique selon au moins l'une des revendications précédentes, caractérisé par le fait que le facteur, déterminant l'élargissement du secteur (2) de la gamme de mesure, est réglable et qu'on utilise un potentiomètre pour le réglage continu et/ou un commutateur (14) pour un réglage par étages.

8. Appareil de mesure numérique selon au moins l'une des revendications précédentes, caractérisé par le fait que le dispositif de commande automatique procède à la sélection du secteur approprié à l'intérieur de la gamme de mesure réglée par un commutateur en ce sens qu'il détermine le facteur d'élargissement présélectionné et la valeur mesurée momentanée et, conformément à ceux-ci, sélectionne le secteur, de manière que la valeur mesurée momentanée soit le plus près possible du milieu de l'échelle.

9. Appareil de mesure numérique selon au moins l'une des revendications précédentes, caractérisé par le fait qu'on utilise une minuterie (15) et/ou un potentiomètre pour le réglage par étages ou continu d'un temps de temporisation pour le déclenchement retardé du signal de commande provoquant la commutation du secteur de la gamme de mesure.

10. Appareil de mesure numérique selon au moins l'une des revendications précédentes, caractérisé par le fait que, par activation de segments de surfaces appropriés, on positionne au moins une valeur de référence à l'intérieur de la partie de l'échelle occupée par le secteur de la gamme de mesure, de préférence au milieu de l'échelle, que des touches d'entrée sont prévues pour le positionnement de la valeur de référence et que tout écart en plus ou en moins de la valeur de référence est signalé par un signal acoustique et/ou optique.

11. Appareil de mesure numérique selon au moins l'une des revendications précédentes, caractérisé par le fait que des deux côtés d'une valeur de référence positionnée au milieu de l'échelle, se trouve une gamme de valeurs limites dont le début et la fin sont de préférence déterminés par la valeur initiale et la valeur finale du secteur de la gamme de mesure et que tout écart en plus ou en moins de la gamme de valeurs limites est indiqué par des signaux, de préférence différents.

12. Appareil de mesure numérique selon la revendication 11, caractérisé par le fait que la gamme de valeurs limites est représentée sous la forme d'une plage de tolérances en plus ou en moins avec indication en pourcentages ou en valeurs absolues.

13. Appareil de mesure numérique selon au moins l'une des revendications précédentes, caractérisé par le fait que la minuterie (15), qui sert au réglage du temps de temporisation pour la commutation du secteur (2) de la gamme de mesure, comporte d'autres positions pour l'introduction d'une ou de plusieurs valeurs de référence et qu'un autre commutateur (16) est prévu pour l'enclenchement d'un signal acoustique et/ou optique pour la surveillance des valeurs limites.

14. Appareil de mesure numérique selon au moins l'une des revendications précédentes, caractérisé par le fait que les segments de surfaces de l'écran de visualisation sont activés par une matrice et que tous les segments de surfaces pouvant être activés ont une superficie sensiblement ponctuelle de même grandeur.

15. Appareil de mesure numérique selon au moins l'une des revendications 1 à 13, caractérisé par le fait que les segments de surface de l'écran de visualisation sont adaptés, quant à leurs formes, aux variantes prévues des échelles et sont en partie très différents en ce qui concerne leur superficie, et que pour l'activation des segments de surfaces, ceux-ci sont mis individuellement à un potentiel opposé vis-à-vis d'une électrode commune, ou que plusieurs contre-électrodes sont formées pour réduire les électrodes à commander individuellement en cas d'emploi de procédés multiplex appropriés.

16. Appareil de mesure numérique selon au moins l'une des revendications précédentes, caractérisé par le fait que l'échelle comporte une division fixe qui reste la même indépendamment de la gamme de mesure complète sélectionnée et du secteur (2) à chaque fois considéré et qu'une adaptation s'effectue par variations de la longueur des traits et des légendes de l'échelle et que les parties invariables de l'échelle sont activées en commun ou préétablies par impression.

17. Appareil de mesure numérique selon au moins l'une des revendications précédentes, caractérisé par le fait qu'une échelle, qui est prévue pour une gamme de mesure complète dont la valeur finale est un multiple décimal de trois, comporte treize traits dont le premier et le dernier sont occultés lorsqu'il s'agit de représenter une gamme de mesure complète ayant une valeur finale qui est un multiple décimal de un, deux, quatre ou cinq et que le facteur d'élargissement est 1, tandis que le secteur de la gamme de mesure comporte à chaque fois onze traits dont le sixième se situe au milieu de l'échelle.

18. Appareil de mesure numérique selon au moins l'une des revendications précédentes, caractérisé par le fait que les segments de surfaces (20) activés pour représenter l'index (17) sont disposés à la même distance parallèlement les uns à côté des autres depuis le début (3) jusqu'à la fin (4) de l'échelle et que le nombre et la position de ces segments de surface (20) sont choisis de manière qu'au niveau de chaque trait (18) de l'échelle se situe un segment de surface (20) et que d'autres segments de surface (20) soient disposés entre les traits (18) de l'échelle.

19. Appareil de mesure numérique selon au moins l'une des revendications précédentes, à l'exception des revendications 2 et 3, caractérisé par le fait qu'on effectue un élargissement linéaire à l'intérieur du secteur (2) de la gamme de mesure et un rétrécissement linéaire dans la gamme de mesure complète (5) située à l'extérieur du secteur (2) et qu'un dépassement de la gamme de mesure complète (5) est signalé par un repère de dépassement (21).

20. Appareil de mesure numérique selon au moins l'une des revendications précédentes, caractérisé par le fait que la valeur initiale et la valeur finale du secteur de la gamme de mesure et de la gamme de mesure complète ainsi qu'en général ainsi la valeur moyenne de l'échelle sont affichées en chiffres (22), mais que pour l'affichage de la valeur mesurée exacte (valeur effective), on utilise en plus un affichage (26) à chiffres sensiblement plus grands.

21. Appareil de mesure numérique selon au moins l'une des revendications précédentes, caractérisé par le fait que tous les traits (18) de l'échelle ou quelques uns d'entre-eux sont respectivement constitués par deux ou plusieurs segments de traits pouvant être activés séparément (18a, 18b) et qui, activés en même temps, augmentent la longueur de chaque trait à chaque fois considéré de l'échelle, et qu'un dispositif automatique d'adaptation (11) veille en ce qu'en cas de commutation de la gamme de mesure, les traits plus longs de l'échelle se situent à un endroit qui garantit une subdivision facilement lisible de la gamme de mesure sélectionnée.

22. Appareil de mesure numérique selon au moins l'une des revendications précédentes, caractérisé par le fait que le réglage grossier du facteur d'élargissement est effectué à la main ou automatiquement en fonction de paramètres déterminés, et que le dispositif automatique d'adaptation (11) de l'échelle effectue le réglage fin du facteur d'élargissement de façon que le secteur (2), visualisé, de la gamme de mesure, soit adapté à la division préétablie de l'échelle.

23. Appareil de mesure numérique selon au moins l'une des revendications précédentes, caractérisé par le fait que les segments de surface pour l'affichage quasi analogique de la valeur mesurée sont visualisés sur l'écran suivant une disposition en forme de cercle, de spirale, d'ondulations ou autres, conformément au cas d'utilisation à chaque fois considéré.

24. Appareil de mesure numérique selon au moins l'une des revendications précédentes, caractérisé par le fait que l'activation des segments (18) des traits et des valeurs de l'échelle peut s'effectuer facultativement de telle sorte que le point zéro de la gamme de mesure complète et/ou du secteur de la gamme de mesure soit situé au début, au milieu ou à la fin de l'échelle à chaque fois considérée.

Fig.1

Fig.2

Fig.3

*Fig.4*

Fig.5